# EUROPEAN PATENT SPECIFICATION

(11) **EP 0 374 244 B1**
(45) Date of publication and mention of the grant of the patent: **28.09.1994**
(21) Application number: 89907945.3
(22) Date of filing: 22.05.1989
(51) Int. Cl.: H01L 27/14, H01L 31/00

(54) **AN IMPROVED METHOD OF FABRICATING CONTACTS FOR SOLAR CELLS**
VERFAHREN ZUR HERSTELLUNG VON SONNENZELLENKONTAKTEN
PROCEDE AMELIORE DE FABRICATION DE CONTACTS POUR CELLULES SOLAIRES

(30) Priority: 10.06.1988 US 205304
(43) Date of publication of application: 27.06.1990
(73) Proprietor: MOBIL SOLAR ENERGY CORPORATION, Billerica, MA 01821 (US)
(72) Inventor: HANOKA, Jack, I., Brookline, MA 02146 (US)
(74) Representative: Kerr, Simonne June
(86) International application number: US8902241
(87) International publication number: WO8912321

(56) References cited:
- US-A- 4 235 644
- US-A- 4 256 513
- US-A- 4 375 007
- US-A- 4 602 120
- US-A- 4 643 913
- US-A- 4 737 197
- Hybrid Circuit Design and Manufacture, R.D. Jones, M. Dekker, Inc., N. York, 1982

## Description

This invention relates to the manufacture of solid state semiconductor devices. More particularly, the invention relates to an improved process for forming a conductive metal contact on the front side of a silicon wafer coated with silicon nitride.

### BACKGROUND OF THE INVENTION

Heretofore a common method of fabricating silicon solar cells has included the steps of: (1) diffusing phosphine into P-type silicon ribbon so as to form a shallow junction, (2) forming on the junction side of the ribbon a thin coating of silicon nitride, (3) forming a grid electrode pattern in the silicon nitride coating by photolithography (using a suitable photoresist composition and etching), (4) coating the other side of the silicon ribbon with an aluminum paste, (5) heating the silicon so as to alloy the aluminum and silicon, (6) plating exposed silicon on both sides of the ribbon with nickel, (7) sintering the nickel to form a nickel silicide, and (8) plating additional metal(s) onto the metal covered portions of the silicon. A more detailed description of such a process can be found in U. S. Patent 4451969.

The steps of forming a grid electrode by photolithography, which necessarily involves removal of residual resist, is extremely effective. However, photolithography involves several time consuming steps and adds a disproportionally high share to the overall cost of forming solar cells.

Illustrating the state of the prior art are U.S. Patents Nos. 4375007, 4388346 and 4640001, and the references cited therein. U.S. Patent 4375007 discloses a silicon solar cell with aluminum-magnesium alloy low resistance contacts. The Al-Mg alloy is mixed with Ni-Sb alloy or Al, in powder form, to form a thick-film metallizing paste useful for making low resistance electrically conductive contacts to a silicon solar cell coated with Si₃N₄.

U.S. Patent 4388346 discloses electrodes for solid state devices. The electrodes are formed by screen-printing through a mask a pattern of ink containing a dispersion of lower melting, sinterable metal coated base metal particles dispersed in a liquid vehicle including a vaporizable binder polymer and a fluorocarbon polymer. On firing the screen-printed device, the coated metal particles sinter without being oxidized to form a contact electrode. An anti-reflection coating is then applied to the cell.

More recently, U.S. Patent 4640001 (Koiwai et al) discloses a solar cell manufacturing method in which a silicon wafer is coated with an anti-reflection coating of silicon nitride by means of plasma CVD deposition at a temperature between 250 degrees C and 600 degrees C. The silicon nitride coating makes the surface of the silicon cell unacceptable for firing screen-printed electrodes. Therefore, the coating is partially removed by etching in the regions where the electrodes are to be formed to insure that the electrodes will bond to the silicon wafer.

At the time this invention was conceived, it was widely recognized that widespread use of photovoltaic solar cells was dependent upon the development of fabrication techniques capable of producing reliable solar cells with a conversion efficiency of 12% or higher at a relatively low cost. The cost of solar cells, like other semiconductor devices, depends on the cost of the starting materials and the cost of converting the starting materials into the finished product. The conversion of silicon into at least 12% efficient silicon solar cells at low cost cannot be accomplished without a suitable low-cost metallization technique for forming the grid electrode.

US-A-4 737 197 discloses a solar cell with an anti-reflection coating and electrodes formed thereon containing Ag-paste doped with P.

US-A-4 643 913 also disclosing a solar cell with an anti-reflection coating uses for the electrodes an Ag-paste with Ti, Mg or Ni powders.

US-A-4 235 644 discloses the use of Ag-paste without dopants to form electrodes on a solar cell without an anti-reflection coating.

### OBJECTS OF THE INVENTION

Accordingly, the primary object is to provide a low cost processing sequence for the fabrication of solar cells in which a metal paste is fired through a silicon nitride layer to form a conductive contact.

Another object of this invention is to provide an improved low cost method of making photovoltaic semiconductor junction devices in which a metal paste is fired through a silicon nitride coating to form a conductive contact with the substrate, while leaving the surrounding silicon nitride to serve as an anti-reflection layer and also as an environmental protector for the substrate.

Still another important object is to provide an improved method of making semiconductor solar cells in which a layer of silicon nitride serves as an anti-reflection coating on each cell, and formation of a metal contact is accomplished through the silicon nitride layer.

Yet another object of the present invention is to provide a method of making solar cells in which a paste employing nickel or silver is fired through a silicon nitride layer to form a conductive contact.

An additional object of this invention is to provide an improved method of fabricating a silicon solar cell with a silicon nitride coating which achieves the previous objects without (a) etching a grid pattern in the silicon nitride layer in preparation for application of a metal contact, and (b) degradation of cell performance in the course of contact formation.

Another object of this invention is to provide an improved method of making silicon solar cells which is less expensive but no less reliable than prior methods of forming nickel or silver contacts.

The foregoing objects are achieved by a solar cell fabrication procedure according to claim 1. The novel method may be practiced with a silicon solar cell which already has a back ohmic contact or the latter contact may be formed after the front surface contact has been formed.

A second embodiment of the present invention is defined in claim 15.

The metal paste that is fired into the substrate must have the following characteristic. First, it must be capable of rapidly penetrating the silicon nitride layer at relatively low temperatures at which the solar cell integrity is not destroyed, i.e., temperatures below about 900 degrees C. Second it must not diffuse into the silicon substrate so as to alter its P-N junction, and thus degrade cell performance. Third, it must not cause the silicon nitride layer to crack during thermal treatment. Fourth, it must not significantly alter the ability of the silicon nitride layer to act as an anti-reflection element.

Other objects of the invention will in part be obvious and will in part appear hereinafter. The invention accordingly comprises the several steps and the relation of one or more of such steps with respect to each of the others which are exemplified in the following detailed disclosure, and the scope of the application of which will be indicated in the claims.

### BRIEF DESCRIPTION OF THE DRAWINGS

For a fuller understanding of the nature and objects of the present invention, reference should be had to the following detailed description which is to be considered together with the accompanying drawing which illustrate a number of the steps involved in making solar cells according to a preferred form of the invention.

Throughout the drawing, like reference numbers refer to similar structure.

In the drawing, the thicknesses and depths of the several coatings and regions are neither shown to scale nor shown exactly in accordance with their relative proportions, for convenience of illustration.

### DETAILED DESCRIPTION OF THE INVENTION

Referring now to the drawing, the preferred embodiment of the invention relates to the production of solar cells from EFG grown P-type silicon ribbon. For this embodiment, there is provided as a starting piece a partially finished cell 1. Partially finished cell 1 has a substrate 2, preferably comprising a length of P-type conductivity silicon ribbon, one side (hereafter the "front side") of which has been provided with a relatively shallow junction 4 (e.g., a junction of between about 3,000 and about 7,000 Angstrom units deep [10 Å = 1 nm]), an N-type (typically N+) conductivity region 6, and a silicon nitride layer 10. The other side (hereinafter the "rear side") of the substrate is preferably provided with a layer of aluminum 12 alloyed to the substrate and a P+ region 14. The P+ region 14 preferably has a depth of from about 1 to about 5 microns.

Partially finished cell 1 may be fabricated by any of a number of means well known in the art. For instance, junction 4 and N+ conductivity region 6 may be formed in a P-type silicon substrate 2 by the diffusion of phosphorus. Layer 12 and P+ region 14 may be formed by coating the rear side of the substrate with a layer of an aluminum paste comprising aluminum powder in a volatile organic vehicle, such as terpineol, diethylene glycol monobutyl ether acetate or ethylcellulose, that can be removed by evaporation or combustion, and then heating the substrate to remove any volatile or pyrolyzable organic components of the paste and to alloy the aluminum to the substrate and form the P+ region. However, other forms of substrate, junction, and rear electrode, and other methods of fabrication, may equally well be employed to provide partially finished cell 1.

Of course, the process provided by this invention is not limited to the production of solar cells from EFG substrates. Thus, for example, cast polycrystalline substrates, epitaxial silicon on metallurgical grade silicon or fine grade polysilicon layers formed by chemical or physical vapor deposition can be used to form solar cells using the present invention. Further, the process is applicable to single crystal silicon. Then, too, the process may be practiced with N-type as well as P-type material. Also, the invention may be applied to substrates other than ribbons or similar flat stock, e.g., circular pieces of material or substrates having an arcuate or polygonal cross-section.

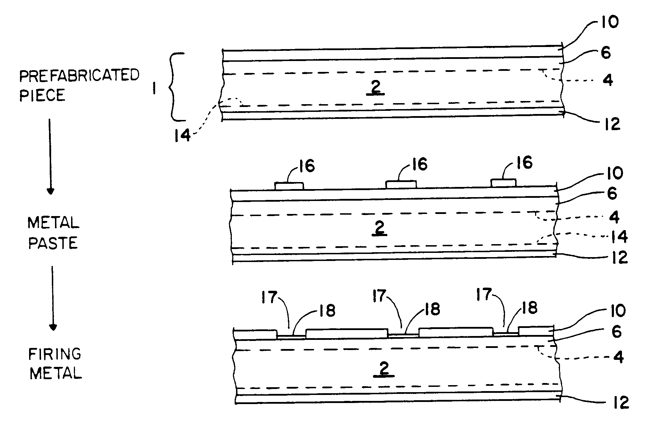

Starting with such a prefabricated piece as shown in Fig. 1, the front side is coated with a paste 16 containing a selected conductive metal, a frit of lead silicate glass or a lead borosilicate glass, and a low boiling liquid organic vehicle such as ethylene glycol monoethyl ether or terpineol in amounts up to 2-10 wt. % of the paste. Preferably, for cost and other considerations, the metal is silver. The paste is applied according to a predetermined electrode pattern, e.g., in the form of a grid electrode comprising a plurality of narrow fingers attached at one end to a bus bar or runner. One form of suitable grid electrode is illuminated in U.S. Patent No. 3686036. Paste 16 may be applied using any of the known techniques which are commonly used in the electronics industry. Screen printing and direct write-on coating techniques are satisfactory.

Once paste 16 has been applied and dried it is ready to be fired. The firing is conducted in a furnace with an oxygen atmosphere. The firing temperature may vary, but in any case it should be adequate to volatize or pyrolyze the organics and melt the glass frit until the frit fires through the silicon nitride layer 10. The time in the furnace will vary with the firing temperature, generally the overall time in the furnace may be between 0.25 and 2.0 minutes, including the time required to bring the substrate up to firing temperature. The concentration of metal, glass frit and organics in paste 16 may vary. Preferably, however, the paste consists of 20 to 70 wt. % metal, 5 to 30 wt. % glass frit, and 1 to 12 wt. % organics. Most preferably, the paste has only about 5 wt. % glass frit and between 1 wt. % to 2.0 wt. % ethylene glycol monoethyl ether or between 1.0 wt. % to 10 wt. % terpineol. The glass frit comprises 5-80 wt. % lead and up to 40 wt. % silicon oxide in the case of a lead silicate glass, and 5-80% lead, 1 to 40 % silicon oxide and 1-30% boron oxide in the case of a lead borosilicate glass.

Temperatures of 650-850 degrees C are suitable for firing the paste, but a temperature of about 800 degrees C is preferred. Thus, for example, a furnace containing ambient air heated to 800 degrees C has been found sufficient to produce the desired results in 15-60 seconds at the firing temperature for pastes which contained silver as the selected conductive metal.

During firing the glass frit in paste 16 becomes fluid and fires through the silicon nitride layer 10 to form depressions 17 and ohmic contact 18. The organics in paste 16 volatize or burn off and the conductive metal and glass frit bond to the front surface of the substrate, forming ohmic contact 18.

In an alternate preferred embodiment, the rear side of the substrate has been coated with an aluminum paste. In this embodiment, the firing of the metal paste through silicon nitride layer 10 on the front side is accomplished simultaneously with firing of the aluminum paste to alloy aluminum to the rear side of the silicon substrate.

In the preferred embodiment of the invention, the conductive metal is silver.

The following example illustrates the preferred mode of practicing the invention.

### EXAMPLE

A partially finished cell of P-type EFG-grown silicon ribbon is provided having a conductivity of about 1-5 ohm-cm. The cell has a shallow P-N junction about 6,000 angstroms deep, and a silicon nitride layer of about 800 angstroms on its front surface. The rear side of the cell has a layer of aluminum alloyed to the silicon.

A layer of silver-containing paste is selectively screen printed onto the silicon nitride layer. The layer of paste is patterned as a multi-fingered grid electrode having the form illustrated in U.S. Patent No. 3686036. The paste contains silver metal, a lead borosilicate glass frit and terpineol as the liquid vehicle. The silver metal is in powder form and the glass frit contains 5-80% lead, 5-30% boron oxide, and 5 to 40% silicon oxide. The silver metal, the glass frit and the vehicle constitute about 70-80 wt. %, 5 wt. % and 15-25 wt. % respectively of the paste.

Once the paste has dried (which may but need not involve heating the paste to evaporate any volatile vehicle), the silicon substrate is passed into an air furnace and heated in air to about 800 degrees C. It is held at that firing temperature for about 15 seconds. Then it is removed from the furnace and allowed to cool to room temperature. The overall time in the furnace is about 2 minutes. The firing step has been found to be sufficient to cause any organics in the paste to volatize and burn and the lead borosilicate glass frit to become sufficiently fluid to fire through the silicon nitride coating and bond to the front surface of the silicon substrate. The glass frit carries the silver with it and permits the silver to make an ohmic contact with the substrate.

EFG substrate solar cells having contacts formed according to the present invention, and exemplified by the foregoing example, have been tested and have yielded pleasant results. Cells made according to this invention have exhibited the following characteristics: an open circuit voltage of 589 mV; a short circuit current density of 30.2 mA per square centimeter; a fill factor of 0.78; and an efficiency of 13.8 percent. The foregoing values are comparable with results obtained with current processing methods which use etching and plating techniques to form ohmic contacts.

The best results were obtained from contacts which received a brief (10-20 seconds) bath in a solution containing fluorine ions after firing. The average values from 8 cells subjected to the bath were calculated as follows: The average open circuit voltage was 588 mV, short circuit current was 29.5 mA per square centimeter; the fill factor was 0.75; and the efficiency was 12.9 percent.

Silicon nitride remaining on the front side of the finished devices serves as an effective anti-reflective coating. In this connection it is to be noted, as previously mentioned, that the silicon nitride coating does not crack during the thermal treatment involved in the heating step.

It should be noted that the back contact may be made of silver which may contain a small amount of aluminum instead of aluminum when the front contact is made of silver. The back contact may be applied immediately after application of the paste defining the front contact has been applied and dried.

## Claims

1. A method of fabricating a solid state photovoltaic solar cell having a fill factor in excess of 0.75 comprising in sequence the steps of (a) providing a silicon substrate (2) having oppositely-facing front and rear surfaces, a P-N junction adjacent the front surface and a layer of silicon nitride (10) on the front surface and (b) forming electrically-conductive silver and aluminum metal contacts bonded to the front and rear surfaces by application and firing of a first silver-containing paste and a second aluminum-containing paste respectively, the silver contact being formed by (i) applying a coating of the first silver-containing paste onto the layer of silicon nitride so as to define a predetermined contact pattern (16) on the layer of silicon nitride, the silver-containing paste comprising silver particles, a glass frit and an organic vehicle and (ii) firing the substrate and the first silver-containing paste so as to cause the paste to penetrate the layer of silicon nitride far enough for the silver particles to engage and form a patterned ohmic contact with the front surface, characterized in that the firing of the substrate and the first silver-containing paste is conducted by (1) heating the substrate to a temperature of about 800 degrees C and (2) holding the substrate at that temperature for a predetermined period of time not exceeding 15 to 60 seconds.

2. A method according to claim 1, characterized in that cooling the substrate to room temperature occurs after it has been fired for said period of time.

3. A method according to claim 1 or 2, characterized in that the firing of the substrate and the first silver-containing paste is conducted in an oxygen-containing atmosphere.

4. A method according to any preceding claim, characterized in that the firing involves holding the substrate at a temperature of about 800 degrees C for a time not exceeding 15 seconds.

5. A method according to any preceding claim, characterized in that the first silver-containing paste comprises a borosilicate glass frit.

6. A method according to claim 5, characterized in that the glass frit is a lead borosilicate glass.

7. A method according to any preceding claim, characterized in that the silicon substrate is polycrystalline.

8. A method according to claim 7, characterized in that the substrate is EFG-grown silicon material.

9. A method according to any preceding claim, characterized in that the first silver-containing paste is fired in a furnace in heated air and the substrate is removed from the furnace and cooled after the firing of the silver-containing paste has been completed.

10. A method according to claim 9, characterized in that the substrate is retained in the furnace for between about 0.25 and 2.0 minutes, including the time required to heat the substrate up to the temperature of about 800 degrees C.

11. A method according to any preceding claim, characterized in that the silver-containing paste comprises 50 to 75 % by weight silver and 5 to 30 % by weight glass frit.

12. A method according to any preceding claim, characterized in that the aluminum metal contact is formed on the rear surface before the silver-containing paste is applied to the layer of silicon nitride.

13. A method according to any of claims 1 to 11, characterized in that the aluminum metal contact is formed by applying a coating of the aluminum-containing paste to the rear surface prior to the firing of the substrate and the silver-containing paste and, during the subsequent firing of the silver-containing paste, the aluminum in the aluminum-containing paste is alloyed to the substrate and forms an aluminum metal contact at the rear surface.

14. A method according to any preceding claim, characterized in that the resulting solar cell has a fill factor of about 0.78.

15. A method of fabricating a solid state photovoltaic solar cell comprising in sequence the steps of (a) providing a silicon substrate (2) having oppositely-facing front and rear surfaces, a P-N junction adjacent the front surface and a layer of silicon nitride (10) on the front surface and (b) forming a first electrically-conductive silver-containing contact and a second electrically-conductive aluminum-containing contact bonded to the front and rear surfaces respectively, the silver-containing contact and the aluminum-containing contact being formed by application and firing of separate pastes containing silver metal and aluminum metal respectively, characterized in that the formation of the contacts is accomplished by the following steps conducted in sequence (1) applying a coating of the aluminum-containing paste to the rear surface in a predetermined rear contact pattern (12), (2) selectively covering the layer of silicon nitride with a coating of the silver-containing paste so as to define a predetermined front contact pattern (16) and (3) simultaneously firing the coatings by heating the substrate in an oxygen-containing atmosphere to a temperature of about 800 degrees C and holding it at that temperature for a period of time not exceeding about 60 seconds sufficient to (1) cause the aluminum in the aluminum-containing coating to alloy with the substrate and thereby form an ohmic contact at the rear surface and (2) cause the coating of the silver-containing paste to penetrate the silicon nitride so that the silver metal content of the silver-containing paste will engage and form a patterned ohmic front contact with the front surface.

16. A method according to claim 15, characterized in that the silver-containing paste also comprises a borosilicate glass frit and an organic vehicle.

17. A method according to claim 15 or 16, characterized in that the substrate is polycrystalline silicon.

18. A method according to claim 17, characterized in that the substrate is EFG-grown silicon material.

## Patentansprüche

1. Verfahren zum Herstellen einer festkörper-fotovoltaischen Solarzelle mit einem Füllfaktor über 0,75, mit den aufeinanderfolgenden Arbeitsschritten:
(a) Vorsehen eines Siliziumsubstrates (2) mit gegenüberliegend zugewandten Vorder- und Rückflächen, eines PN-Überganges, welcher der Vorderfläche benachbart ist und einer Schicht aus Siliziumnitrit (10) auf der Vorderfläche und
(b) Ausbilden von elektrisch leitfähigen Silber- und Aluminium-Metall-Kontakten, die mit den Vorder- und Rückflächen durch Aufbringen und Erhitzen einer ersten Silber enthaltenden Paste bzw. einer zweiten Aluminium enthaltenen Paste verbunden sind, wobei der Silberkontakt durch (i) Aufbringen einer Beschichtung aus einer ersten Silber enthaltenden Paste auf die Schicht aus Siliziumnitrit gebildet wird, so daß ein vorgegebenes Kontaktmuster (16) auf der Schicht aus Siliziumnitrit festgelegt wird, wobei die Silber enthaltende Paste Silberpartikel, eine Glasmasse und ein organisches Bindemittel umfaßt und (ii) Erhitzen des Substrates der ersten Silber enthaltenden Paste, so daß die Paste in ausreichendem Maße in die Schicht aus Siliziumnitrit für ein Eingreifen der Silberpartikel eindringen kann und einen gemusterten ohmschen Kontakt mit der Vorderfläche bildet, dadurch gekennzeichnet, daß das Erhitzen des Substrates und der ersten Silber enthaltenden Paste durch (1) Heizen des Substrats auf eine Temperatur von ungefähr 800° C und (2) Halten des Substrates auf der Temperatur für eine vorgegeben Zeitdauer, welche 50 bis 60 Sekunden nicht überschreitet, durchgeführt wird.

2. Verfahren nach Anspruch 1, dadurch gekennzeichnet, daß das Abkühlen des Substrates auf Raumtemperatur nach dem Heizen für die vorgegebene Zeitdauer stattfindet.

3. Verfahren nach Anspruch 1 oder 2, dadurch gekennzeichnet, daß das Heizen des Substrates und der ersten Silber enthaltenden Paste in einer Sauerstoff beinhaltenden Atmosphäre durchgeführt wird.

4. Verfahren nach einem der vorgenannten Ansprüche, dadurch gekennzeichnet, daß das Heizen ein Halten des Substrates auf einer Temperatur von 800° C für eine Zeitdauer enthält, welche 15 Sekunden nicht überschreitet.

5. Verfahren nach einem der vorgenannten Ansprüche, dadurch gekennzeichnet, daß die erste Silber enthaltende Paste eine Borsilikat-Glasschmelze umfaßt.

6. Verfahren nach Anspruch 5, dadurch gekennzeichnet, daß die Glasschmelze aus einem Bleiborsilikatglas besteht.

7. Verfahren nach einem der vorgenannten Ansprüche, dadurch gekennzeichnet, daß das Siliziumsubstrat polychristalin ist.

8. Verfahren nach Anspruch 7, dadurch gekennzeichnet, daß das Substrat aus einem EFG-gewachsenen Siliziummaterial besteht.

9. Verfahren nach einem der vorgenannten Ansprüche, dadurch gekennzeichnet, daß die erste Silber enthaltende Paste in einem Heißluft-Ofen geheizt wird und das Substrat aus dem Ofen entfernt und abgekühlt wird, nachdem das Heizen der Silber enthaltenden Paste beendet ist.

10. Verfahren nach Anspruch 9, dadurch gekennzeichnet, daß das Substrat in dem Ofen zwischen ungefähr 0,25 und 2 Minuten gehalten wird, wobei die Zeit enthalten ist, welche zum Aufheizen des Substrats auf eine Temperatur von 800° C notwendig ist.

11. Verfahren nach einem der vorgenannten Ansprüche, dadurch gekennzeichnet, daß die Silber enthaltende Paste 50 bis 75 Gewichts-% Silber und 5 bis 30 Gewichts-% Glasschmelze umfaßt.

12. Verfahren nach einem der vorgenannten Ansprüche, dadurch gekennzeichnet, daß der Aluminium-Metallkontakt auf der Rückfläche gebildet wird, bevor die Silber enthaltende Paste auf die Schicht aus Siliziumnitrit aufgebracht wird.

13. Verfahren nach einem der Ansprüche 1 bis 11, dadurch gekennzeichnet, daß der Aluminium-Metallkontakt durch Aufbringen einer Beschichtung aus Aluminium enthaltender Paste auf die Rückfläche, vor dem Heizen des Substrats und der Silber enthaltenden Paste, ausgebildet wird und daß während des nachfolgenden Heizens der Silber enthaltenden Paste die Aluminium enthaltenden Paste auf das Substrat legiert wird und einen Aluminium-Metallkontakt an der Rückfläche bildet.

14. Verfahren nach einem der vorstehenden Ansprüche, dadurch gekennzeichnet, daß die resultierende Solarzelle einen Füllfaktor von ungefähr 0,78 aufweist.

15. Verfahren zum Herstellen einer festkörper-fotovoltaischen Solarzelle mit den aufeinanderfolgenden Arbeitsschritten:
(a) Vorsehen eines Siliziumsubstrates (2) mit gegenüberliegend zugewandten Vorder- und Rückflächen, eines PN-Überganges, welcher der Vorderfläche benachbart ist und einer Schicht aus Siliziumnitrit (10) auf der Vorderfläche und
(b) Ausbilden eines ersten elektrisch leitfähigen Silber enthaltenden Kontaktes und eines zweiten elektrisch leitfähigen Aluminium enthaltenden Kontaktes, welche jeweils mit den Vorder- und Hinterflächen verbunden sind, wobei der Silber enthaltende Kontakt und der Aluminium enthaltende Kontakt durch Aufbringen und Heizen von separaten Pasten gebildet werden, welche Silber- bzw. Aluminiummetall enthalten, dadurch gekennzeichnet, daß die Anordnung der Kontakte durch die nachfolgenden, aufeinanderfolgenden Arbeitsschritte erreicht wird: (1) Aufbringen einer Beschichtung aus der Aluminium enthaltenden Paste auf die Rückfläche in einem vorgegebenen Rückkontaktmuster (12), (2) selektives Bedekken der Schicht aus Siliziumnitrit mit einer Beschichtung aus der Silber enthaltenden Paste, so daß ein vorgegebenes vorderes Kontaktmuster (16) festgelegt wird und (3) gleichzeitiges Heizen der Beschichtungen durch Aufheizen des Substrats in einer Sauerstoff enthaltenden Atmosphäre auf eine Temperatur von ungefähr 800° C und dessen Halten auf der Temperatur, für eine Zeitdauer, welche ungefähr 60 Sekunden nicht überschreitet, die ausreicht, um zu bewirken: (1.) Daß das Aluminium der Aluminium enthaltenden Beschichtung das Substrat legiert und dadurch einen ohmschen Kontakt an der Rückfläche bildet und (2.) daß die aus Silber enthaltende Paste bestehende Beschichtung in das Siliziumnitrit eindringt, so daß die Silbermetallkomponente der Silber enthaltenen Paste eindringt und einen gemusterten ohmschen Vorderkontakt mit der Vorderfläche bildet.

16. Verfahren nach Anspruch 15, dadurch gekennzeichnet, daß die Silber enthaltende Paste eine Borsilikat-Glasschmelze und ein organisches Bindemittel umfaßt.

17. Verfahren nach Anspruch 16, daß das Substrat aus einem polykristallinen Silizium besteht.

18. Verfahren nach Anspruch 17, dadurch gekennzeichnet, daß das Substrat aus einem EFG-gewachsenen Siliziummaterial besteht.

## Revendications

1. Un procédé de fabrication d'une cellule solaire photovoltaïque monobloc ayant un facteur de remplissage supérieur à 0,75, comprenant successivement les étapes consistant à (a) prévoir un substrat de silicium (2) présentant des surfaces avant et arrière orientées dans des directions opposées, une jonction P-N adjacente à la surface avant et une couche de nitrure de silicium (10) sur la surface avant et (b) former des contacts en métal d'argent et d'aluminium conducteurs d'électricité, assemblés aux surfaces avant et arrière par application et cuisson respectivement d'une première pâte à teneur en argent et d'une seconde pâte à teneur en aluminium, le contact d'argent étant formé par (i) application d'un revêtement de la première pâte à teneur en argent sur la couche de nitrure de silicium, de manière à définir un modèle de contact prédéterminé (16) sur la couche de nitrure de silicium, la couche de nitrure de silicium comprenant des particules d'argent, une fritte de verre et un agent véhiculaire organique et (ii) cuisson du substrat et de la première pâte à teneur en argent, de manière à faire pénétrer la pâte suffisamment loin dans la couche de nitrure de silicium pour que les particles d'argent viennent en prise et forment un contact ohmique modelé avec la surface avant, caractérisé en ce que la cuisson du substrat et la la première pâte à teneur en argent est effectuée en (1) chauffant le substrat à une température d'environ 800 degrés C et (2) en maintenant le substrat à cette température pendant un laps de temps prédéterminé ne dépassant pas de 15 à 60 secondes.

2. Un procédé suivant la revendication 1, caractérisé en ce que le refroidissement du substrat à température ambiante se produit après qu'il a été cuit pendant ledit laps de temps.

3. Un procédé suivant la revendication 1 ou 2, caractérisé en ce que la cuisson du substrat et la première pâte à teneur en argent est effectuée dans une atmosphère à teneur en oxygène.

4. Un procédé suivant l'une quelconque des revendications précédentes, caractérisé en ce que la cuisson implique le maintien du substrat à une température d'environ 800 degrés C pendant un laps de temps ne dépassant pas 15 secondes.

5. Un procédé suivant l'une quelconque des revendications précédentes, caractérisé en ce que la première pâte à teneur en argent comprend une fritte de verre borosilicaté.

6. Un procédé suivant la revendication 5, caractérisé en ce que la fritte de verre est un verre borosilicaté au plomb.

7. Un procédé suivant l'une quelconque des revendications précédentes, caractérisé en ce que le substrat de silicium est polycristallin.

8. Un procédé suivant la revendication 7, caractérisé en ce que le substrat est un matériau de silicium à croissance d'EFG.

9. Un procédé suivant l'une quelconque des revendications précédentes, caractérisé en ce que la première pâte à teneur en argent est cuite dans un four dans de l'air chauffé et que le substrat est enlevé du four et refroidi après que la cuisson de la première pâte à teneur en argent est terminée.

10. Un procédé suivant la revendication 9, caractérisé en ce que le substrat est retenu dans le four pendant environ 0,25 à 2,0 minutes, y compris le temps nécessaire pour chauffer le substrat à une température d'environ 800 degrés C.

11. Un procédé suivant l'une quelconque des revendications précédentes, caractérisé en ce que la pâte à teneur en argent comprend de 50 à 75% en poids d'argent et de 5 à 30% en poids de fritte de verre.

12. Un procédé suivant l'une quelconque des revendications précédentes, caractérisé en ce que le contact en métal d'aluminium est formé sur la face arrière avant que la pâte à teneur en argent n'est appliquée sur la couche de nitrure de silicium.

13. Un procédé suivant l'une quelconque des revendications 1 à 11, caractérisé en ce que le contact en métal d'aluminium est formé par application d'un revêtement de la pâte à teneur en aluminium sur la surface arrière avant cuisson du substrat et de la pâte à teneur en argent et que, pendant la cuisson ultérieure de la pâte à teneur en argent, l'aluminium dans la pâte à teneur en aluminium est allié au substrat et forme un contact en métal d'aluminium sur la surface arrière.

14. Un procédé suivant l'une quelconque des revendications précédentes, caractérisé en ce que la cellule solaire qui en résulte a un facteur de remplissage d'environ 0,78.

15. Un procédé de fabrication d'une cellule solaire photovoltaïque monobloc, comprenant successivement les étapes consistant à (a) prévoir un substrat de silicium (2) présentant des surfaces avant et arrière orientées dans des directions opposées, une jonction P-N adjacente à la surface avant et une couche de nitrure de silicium (10) sur la surface avant et (b) former un premier contact à teneur en argent conducteur d'électricité et un second contact à teneur en aluminium conducteur d'électricité, assemblés aux surfaces respectivement avant et arrière, le contact à teneur en argent et le contact à teneur en aluminium étant formés par application et cuisson de pâtes séparées contenant respectivement du métal d'argent et du métal d'aluminium, caractérisé en ce que la formation des contacts est réalisée par les étapes suivantes effectuées successivement: (1) application d'un revêtement de la pâte à teneur en aluminium sur la surface arrière suivant un modèle de contact arrière prédéterminé (12), (2) recouvrement sélectif de la couche de nitrure de silicium d'un revêtement de la pâte à teneur en argent, de manière à définir un modèle de contact avant prédéterminé (16) et (3) cuisson simultanée des revêtements en chauffant le substrat dans une atmosphère à teneur en oxygène à une température d'environ 800 degrés C et en le maintenant à cette température pendant un laps de temps, ne dépassant pas 60 secondes, suffisant pour (1) faire allier l'aluminium dans le revêtement à teneur en aluminium avec le substrat et former ainsi un contact ohmique sur la surface arrière et (2) faire pénétrer le revêtement de la pâte à teneur en argent dans le nitrure de silicium, de sorte que la teneur en métal d'argent de la pâte à teneur en argent vient en prise et forme un contact avant ohmique modelé avec la surface avant.

16. Un procédé suivant la revendication 15, caractérisé en ce que la pâte à teneur en argent comprend également une fritte de verre borosilicaté et un agent véhiculaire organique.

17. Un procédé suivant la revendication 15 ou 16, caractérisé en ce que le substrat est du silicium polycristallin.

18. Un procédé suivant la revendication 17, caractérisé en ce que le substrat est un matériau de silicium à croissance d'EFG.
